Europäisches Patentamt

European Patent Office

Office européen des brevets

(19)

(11) Publication number: **0 352 758**
**A2**

## (12) EUROPEAN PATENT APPLICATION

(21) Application number: **89113727.5**

(22) Date of filing: **25.07.89**

(51) Int. Cl.⁴: **H03K 17/95**

(30) Priority: **28.07.88 DE 3825628**

(43) Date of publication of application:
**31.01.90 Bulletin 90/05**

(84) Designated Contracting States:
**CH DE FR IT LI**

(71) Applicant: **Gebhard Balluff Fabrik**
**feinmechanischer Erzeugnisse GmbH & Co.**
**Gartenstrasse 21**
**D-7303 Neuhausen a.d.F.(DE)**

(72) Inventor: **Kammerer, Heinz**
**Achalmstrasse 29**
**D-7302 Ostfildern(DE)**
Inventor: **Jäck, Fritz**
**Hochausstrasse 38**
**D-7303 Neuhausen(DE)**

(74) Representative: **Hoeger, Stellrecht & Partner**
**Uhlandstrasse 14 c**
**D-7000 Stuttgart 1(DE)**

(54) **Method and circuit configuration for detecting rapid damping changes with a proximity switch.**

(57) The invention relates to a method for detecting rapid damping changes in the oscillator input circuit of a proximity switch. A high-frequency oscillation generated by the oscillator and amplitude-modulated by the damping changes is demodulated such that a demodulated signal voltage which fluctuates with the frequency of the damping changes is obtained. This signal voltage is amplified as ac voltage and the amplified signal voltage is converted by means of threshold switching devices to a pulse sequence with a pulse sequence frequency which corresponds to the frequency of the voltage changes in the signal voltage.

FIG. 1

## METHOD AND CIRCUIT CONFIGURATION FOR DETECTING RAPID DAMPING CHANGES WITH A PROXIMITY SWITCH

The invention relates to a method for detecting rapid damping changes in the oscillator input circuit of a proximity switch comprising an oscillator which oscillates at high frequency and a demodulator and to a circuit configuration for performing this method.

It is known with the aid of proximity switches to detect objects approaching a sensor surface of the proximity switch by evaluating the damping changes caused by the objects in the oscillator input circuit of the proximity switch. It has been shown that there is an upper limit for the frequency at which such damping changes are still reliably detectable. In the case of inductive proximity switches, this upper limit lies at approximately 5 kHz because sensor-internal time constants, especially of the oscillator and the demodulator, have a limiting effect at higher frequencies. In addition, the amplitude changes in the oscillation of the oscillator when the damping occurs with high frequency, as, for example, in the case of a gear moving in front of the sensor surface of the proximity switch, are only faint, which makes further signal processing at least difficult, if not impossible.

In view of the upper frequency limit in proximity switches for detecting objects following one another rapidly, for example, the teeth of a gear in front of the sensor surface of a proximity switch, in applications where high speeds are to be detected by sensing the teeth of a gear, one has hitherto resorted to magnetically/inductively acting sensors wherein the flux change induced in a sensor coil by a moving permanent magnet is evaluated or the magnetic flux change in a magnetic field sensor such as, for example, a magnetoresistor sensor or a Hall element. Suitable sensors are marketed, for example, by the Valvo company under the type designation KMZ 10B and by the Siemens company under the designations KSY 10, KSY 13 and KSY 20. Sensors with a sensor coil which sense the flux change $d\phi/dt$ have the disadvantage that only the detection of sufficiently rapid magnetic flux changes, i.e., only the detection of relatively high frequencies, is possible as the voltage induced in the sensor coil is proportional to the speed of the magnetic flux change. Therefore, low speeds·at which the frequency with which the permanent magnets are moved past the sensor coil lies below a sensor-typical lower limit frequency cannot be detected. In addition, there is no possibility for determining whether a stationary machine part is located in front of the sensor or not. A further disadvantage of the two magnetically/inductively acting sensors referred to hereinabove is that permanent magnets are required and for the express purpose of speed detection these have to be produced in the rotating component or attached to it and tend to become soiled by ferromagnetic materials from the environment of the sensors.

Proceeding from the prior art, the object underlying the invention is to indicate a method and a circuit configuration with which it is possible to detect even rapid damping changes in the oscillator input circuit of a proximity switch.

As far as the method is concerned, this object is accomplished, in accordance with the invention, in that the high-frequency oscillation of the oscillator which is amplitude-modulated by the damping changes is demodulated such that a demodulated signal voltage which fluctuates with the frequency of the damping changes is obtained, in that this signal voltage is amplified as ac voltage, and in that this amplified signal voltage is converted with the aid of threshold switching devices to a pulse sequence with a pulse sequence frequency corresponding to the frequency of the voltage changes in the signal voltage. A high-frequency oscillation of the oscillator within the meaning of the present application is to be understood as a frequency of several hundred kilohertz, for example, 500 kHZ.

A special advantage of the inventive method is that by generation of a high-frequency, amplitude-modulated oscillation - with the aid of an oscillator operating in an analog manner instead of one of the conventional oscillators whose amplitude of oscillation returns to zero as a result of the damping - by demodulation of this oscillation without the conventional mean value formation over quite a long period of time, and by am plification of the demodulated signal as ac voltage, it is possible to detect even damping changes with a frequency which has so far not been attainable.

A fundamental thought underlying the invention is to amplify the ac voltage component separately from the dc voltage component of the demodulated signal voltage and to feed this amplified ac voltage component to the threshold switching devices. This eliminates the so far very critical adjustment of the sensor with respect to a threshold, as has always been necessary in the conventional evaluating circuits. Amplification of the ac voltage component can now be carried out up into the range of overdrive of the amplifier device without any resulting disadvantages for recognition of the threshold.

It has proven advantageous to derive a dynamically variable reference voltage corresponding to the damping state of the proximity switch from the demodulated signal voltage for the threshold switching devices as a high sensitivity of the threshold switching devices is achieved by the dynamic follow-up of the reference voltage and, therefore, a weak amplitude modulation of the oscillation of the oscillator can also be evaluated with high precision.

In accordance with the invention, the mean value of the periodically sampled maximum and minimum values of the demodulated signal voltage is preferably used as refer ence voltage as the maximum values and the minimum values can be stored relatively simply for a certain period of time by means of sampling and holding circuits and used to form a reference voltage which compensates the instantaneous value of the oscillator parameters such as, for example, a temperature-related drift of the oscillator (e.g. its frequency).

In a development of the invention, it has, furthermore, proven advantageous for the signal changes at the output of the threshold switching devices to be continuously detected and, in the event of a drop in the frequency of the signal changes below a given limit, for a switchover to be carried out from the variable reference voltage to a fixed reference voltage which is settable at a given value and vice-versa, i.e., a switchover from the fixed reference voltage to the variable reference voltage when the limit is exceeded starting from a lower frequency. This switchover possibility enables damping changes occurring with very low frequency as well as the static operating conditions to also be detected, which would not be possible in the case of formation of the reference voltage as a function of the difference occurring in a relatively short period of time between the maximum voltage and the minimum voltage.

A circuit configuration for generating signal pulses as a function of elements which are to be detected approaching the sensor surface of a proximity switch comprising a oscillator, a demodulator which is connected to the output of the oscillator and threshold switching devices for the demodulated signal which are connected to the output of the demodulator and characterized in that the oscillator is designed as an oscillator which operates in an analog manner and generates a high-frequency oscillation which is amplitude-modulated by the damping changes, in that the demodulator is designed such that a demodulated signal following the variable mean time value of the oscillator output signal is obtained at its output in the form of a demodulated signal voltage which fluctuates with the frequency of the damping changes and this signal voltage is amplified as ac voltage, and in that this signal voltage is convertible by the threshold switching devices to a pulse sequence with a pulse sequence frequency corresponding to the frequency of the voltage changes in the signal voltage, has proven expedient for performance of the inventive method.

It has proven advantageous for the threshold switching devices to comprise an ac amplifier for generating an ac voltage with the frequency of the demodulated signal voltage, it being particularly expedient for the ac amplifier to be designed as an amplifier with amplitude limitation and to be dimensioned or connected such that a rectangular pulse sequence is obtained at its output. Such amplifiers are, for example, available as integrated circuits for signal evaluation in tachogenerators and operate with high sensitivity and precision.

It is also favorable for an ac amplifier (which, in this case, is not overdriven) to be followed by a trigger circuit which operates with a reference voltage adapted to the operating point of the amplifier.

In a particularly preferred embodiment of a circuit configuration for performing the inventive method, the demodulator comprises separate demodulator units for demodulating the positive and the negative signal components of the amplitude-modulated oscillation of the oscillator and a differential amplifier for adding up the demodulated signal components to the demodulated signal voltage, while the threshold switching devices comprise a trigger circuit, to the input of which the demodulated signal voltage can be fed and for which a variable reference voltage can be generated with the aid of a maximum value detector and a minimum value detector, the inputs of the detectors being connected to the output of the differential amplifier, while their output signals are subtracted from one another to form the reference voltage.

The special advantage of this circuit configuration is, firstly, that by the separate demodulation of the positive and the negative signal components and by the addition of the signal components, a correspondingly higher demodulated signal voltage possessing pronounced maxima and minima even in the case of slight amplitude modulation of the oscillation of the oscillator is obtained. A further advantage of the circuit configura tion is that with the aid of the two detectors, the current voltage values for the maxima and minima can be detected and evaluated for formation of a reference voltage which is precisely symmetrical with the amplitude change in the demodulated signal. A very high sensitivity of the circuit configuration is thereby achieved and it is, therefore, possible to detect damping changes of high frequency. Greater noise immunity is also achieved.

It has also proven advantageous for the inventive circuit configuration to comprise switchover devices for applying to the threshold switching devices or the trigger circuit, in the event of a drop in the frequency of the signal changes at the output of the threshold switching devices, a settable fixed reference voltage instead of the variable reference voltage and vice-versa. The switchover devices preferably comprise in series connection a monostable multivibrator connected to the output of the threshold devices, a low-pass filter, a trigger stage and a mode selector switch with the aid of which a switchover from a variable reference voltage to a reference voltage with a fixed setting can be carried out for the threshold switching devices. At the same time, an amplifier located behind the demodulator in the signal path can, if appropriate, be bypassed as the demodulated signal in the case of low frequency of the damping changes may without special amplification have a sufficiently high level for driving the threshold switching devices.

Finally, in the implementation of a circuit configuration according to the invention, it is advantageous to provide counting devices for counting the pulses of the pulse sequence generated by the threshold switching devices and for producing a digital frequency or speed indication corresponding to the count that is periodically reached.

Further details and advantages of the invention are explained more fully hereinbelow with reference to drawings which show:

Figure 1 a block diagram of a first preferred embodiment of a circuit configuration for performing the inventive method;

Figure 2 a block diagram of a second circuit configuration suitable for particularly high frequencies for performing the inventive method;

Figure 3 schematic diagrams of the voltages with respect to time for the various points of the circuit according to Figure 2; and

Figure 4 a circuit diagram of a preferred embodiment of an inventive circuit configuration.

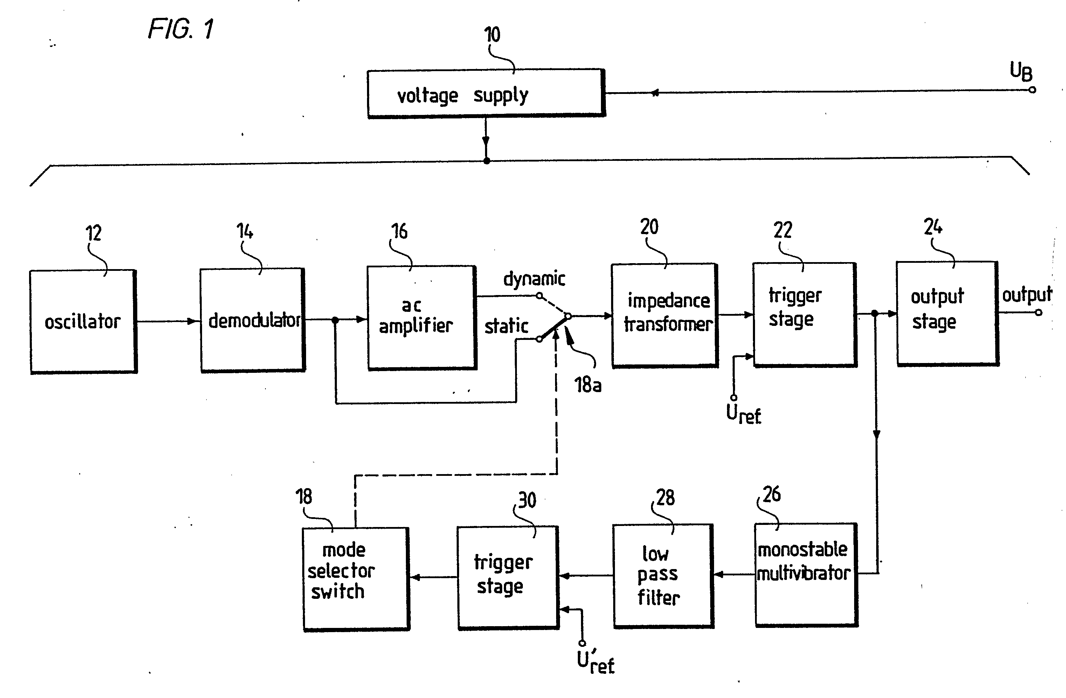

Figure 1 shows an inventive circuit configuration with a common voltage supply 10 for the individual circuit blocks. Their connection to the voltage supply 10 is indicated only schematically. It will be understood that the voltage supply 10 can generate, if appropriate, several different voltages for the individual circuits from an externally available operating voltage $U_B$.

The actual circuit comprises on the input side an oscillator 12 followed by a demodulator 14, the output of which is connected to an ac amplifier 16. In the position of the switching contact 18a of a mode selector switch 18 (shown by a dashed line), the output of the ac amplifier 16 is connected via an impedance transformer 20 to a trigger stage 22, the output of which is connected, on the one hand, to an output stage 24 of the circuit configuration, and, on the other hand, to switch-over devices which, in this embodiment, comprise a monostable multivibrator 26 which is connected on the input side thereof to the output of the trigger stage 22 and on the output side, via a low-pass filter 28, to a further trigger stage 30, the output of which is connected to the mode selector switch 18. Each trigger stage 22 and 30 comprises an additional input connected to a properly selected reference voltage $U_{ref}$ and $U'_{ref}$, respectively.

The circuit configuration according to Figure 1 operates as follows: So long as the sensor surface of the proximity switch, normally comprising only blocks 12, 14, 22 and 24, has no object in front of it causing damping of the oscillator input circuit, the oscillator 12 oscillates at its resonant frequency and with a given ampli tude. If a damping object is moved towards the oscillator, its input circuit is then damped and the oscil lator oscillates with lower amplitude. If the damping objects, for example, the teeth of a rotating gear, are now moved past the sensor surface with a high repetition frequency, and if, furthermore, the oscillator is not designed as an oscillator whose amplitude of oscillation returns to zero as a result of the damping, but as an oscillator which operates in an analog manner, with its amplitude of oscillation varying proportionally with the degree of the damping, there then appears at the output of the oscillator a high-frequency signal which is amplitude-modulated in accordance with the frequency of the damping changes. The amplitude-modulated oscillator output signal is demodulated by the demodulator 14, for example, with a demodulator which is designed in the fashion of an AM radio receiver and delivers at the output an ac voltage with the frequency of the damping changes. This ac voltage is amplified by the ac amplifier 16 which, if appropriate, can be overdriven to provide a rectangular pulse sequence at its output. In the embodiment according to Figure 1, the amplified ac voltage from the output of the ac amplifier is applied, via the impedance transformer 20, to the signal input of a trigger stage 22 which delivers at the output side a pulse sequence with the frequency of the ac voltage at the output of the amplifier 16. The pulse sequence is then converted in the output stage 24 to the desired output signal, in particular, a speed signal.

The output signal of the trigger stage 22 is, furthermore, present at the input of the monostable multivibrator 26, the output of which is connected via an integrator or the low-pass filter 28 to the input of the further trigger stage 30. So long as the frequency of the pulse sequence at the output of the trigger stage 22 is sufficiently high, the low-pass filter 28 delivers to the trigger stage 30 a sufficiently high voltage to keep the output signal of the trigger stage 30 at a first level at which the mode selector switch keeps the switching contact 18a in the "dynamic" (dashed line) position shown. In this position, the output of the ac amplifier 16 is connected to the input of the impedance transformer 20. If the frequency of the signal sequence at the output of the trigger stage 22 drops to or below a given limit, the pulses delivered to the low-pass filter 28 by the monostable multivibrator 26 will be spaced at such a distance from one another that the output voltage of the low-pass filter 28 will drop significantly. This will cause the trigger stage 30 to move into its second switching state, and hence switch over the mode selector switch 18 such that its switching contact 18a assumes the "static" position indicated by an unbroken line, connecting the output of the demodulator 14 directly to the input of the impedance transformer 20, in which case the ac amplifier 16 is bypassed. At the same time, the reference voltage for the trigger stage 22 is generally switched over to a different value, the corresponding switch means not being shown in the drawings. Until this point in time, it is preferably adapted to the operating point setting of the ac amplifier 16. When the lower limit frequency of the pulse sequence at the output of the trigger stage 22 is exceeded again in the upward direction, there is a switchover again to operation with the ac amplifier and associated reference voltage for the trigger stage 22. It will be understood that the frequency ranges in which the circuit configuration operates during operation with ac amplifier 16 and without the ac amplifier must overlap in order to at all times reliably achieve automatic switchover between the two possible operating modes.

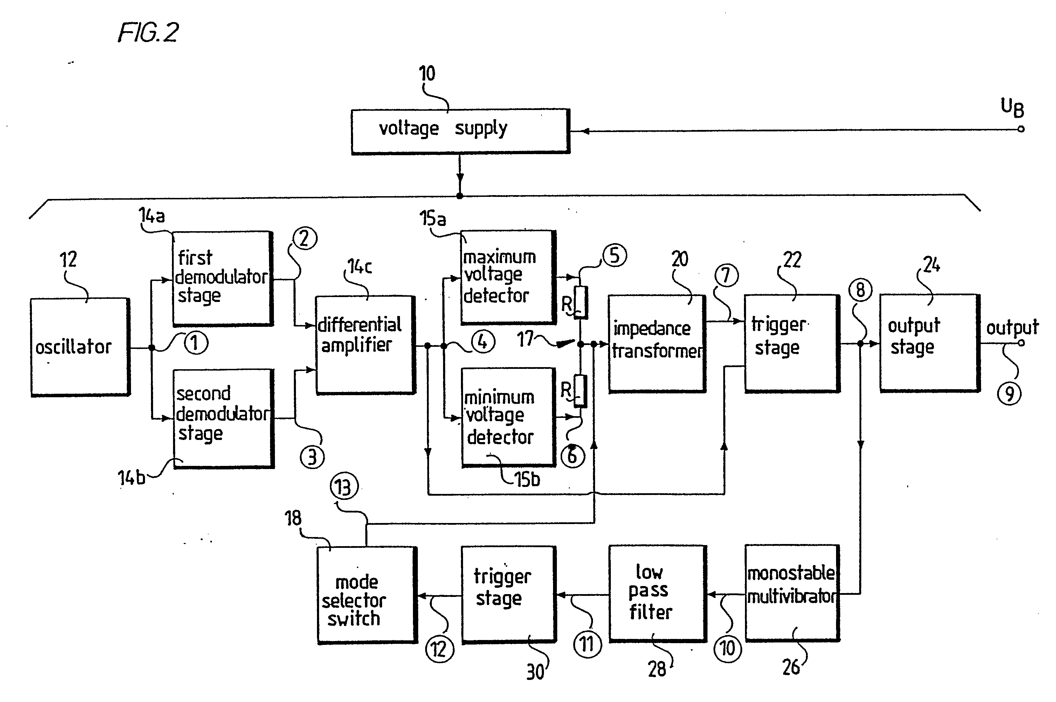

In the inventive circuit configuration shown in Figure 2, the demodulator 14 consists of a first demodulator stage 14a for demodulating the positive signal component of the oscillator output signal, a second demodulator stage 14b for demodulating the negative signal component, and a differential amplifier 14c which in the final effect adds the demodulated signals owing to their different polarity and simultaneously amplifies them. A dc voltage with an amplitude which fluctuates with the cycle of the damping changes is obtained at the output of the differential amplifier 14c. This signal is fed to a maximum voltage detector 15a and a minimum voltage detector 15b where the extreme values of the voltages determined thereby are stored until the next sampling operation. The stored voltage values are applied to a voltage divider (generally designated 17) comprising two identical resistors R, so that a voltage corresponding exactly to the (fluctuating) mean value of the demodulated signal from the output of the differential amplifier 14c is available at the tap of the voltage divider. This voltage is applied via the impedance transformer 20 as reference voltage to the trigger stage 22, the signal input of which receives the demodulated signal from the output of the differential amplifier 14c. The trigger stage 22 operates very accurately, as the dynamically variable reference voltage generated in the manner described above to some extent forms the zero line for the modulation signal obtained by demodulation of the oscillator voltage, the zero passages of the modulation signal being precisely detectable by the trigger stage 22.

In the embodiment shown in Figure 2, the mode selector switch 18 comprises internal switching devices, with the aid of which a settable reference voltage can be applied to the input of the impedance transformer 20 when the frequency of the pulse sequence at the output of the trigger stage 22 drops below the predetermined limit. By virtue of the design of the peak voltage detectors 15a, 15b and the choice of the resistance values for resistors R, it is ensured that this new static reference voltage overrides the dynamic reference voltage and makes it ineffective.

Expediently, the frequency limit at which the mode of operation switchover is to take place will be selected such that there are still sufficient power reserves with respect to the switching frequency in the static mode. On the other hand, the frequency limit for the dynamic mode must be sufficiently large to avoid amplitude variations in the trigger reference voltage caused by the lower limit frequency of the two peak voltage detectors. The frequency range 100 to approximately 200 Hz is to be regarded as a practicable frequency limit.

Having shown and described the overall operation of the method and circuit configuration according to the invention in a more general manner, the applicant now wishes to point out, in addition, that a conventional oscillator whose amplitude of oscillation returns to zero as a result of damping is disclosed, for example, in Figure 1 of the applicant's earlier U.S. patent 4,433,309 which is incorporated herein by reference. This U.S. patent discloses an oscillator which in an undamped condition oscillates with a given frequency and a predetermined amplitude, while oscillation completely ceases as soon as the oscillator is damped by an external element sufficiently close to its sensor surface and the open side of the magnetic pot core surrounding its feeler coil, respectively. On the other hand, analog oscillators of the type used in accordance with the present invention are well known commercial elements wherein the amplitude of oscillation is continuously reduced when the quality factor Q of the resonant circuit is continuously reduced by the approach of an external damping element. An example of such an analog oscillator is shown as item 52 of the brochure available from Carranti Interdesign Inc., Sunnyvale, Ca., chapters 4 to 23, Monochip design Kit, 3rd edition, 1980.

Furthermore, regarding peak voltage detection circuits 15a and 15b, reference is made to "Databook Linear and Conversion Products", 1984, of Precision Monolithics, Inc., pages 14 to 31, Figures 1 and 2, showing detection circuits useful for realizing the present invention.

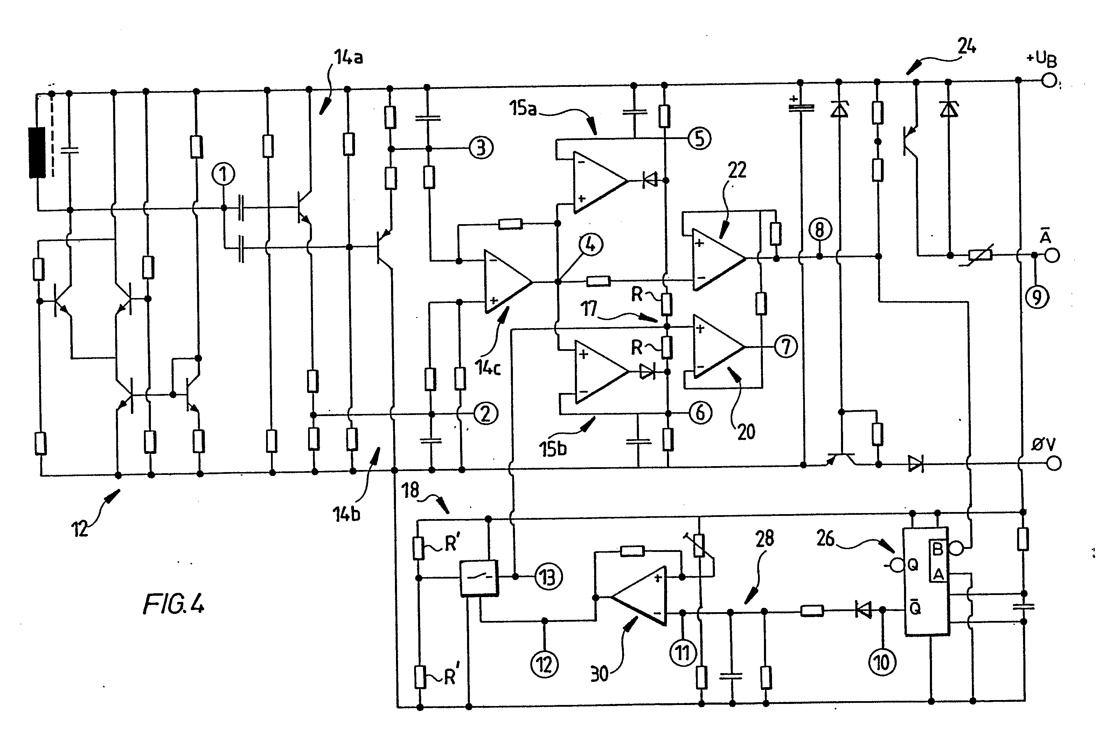

In connection with trigger stage 22, in addition to the explanations given above, it should be observed that the reference voltage for trigger stage 22 is selected differently for the static and dynamic modes of operation. More specifically, in the dynamic mode of operation, the reference voltage is obtained at the connecting point of resistors R, R at the output of peak voltage detection circuits 15a, 15b and delivered to the reference voltage input 7 of trigger stage 22 via impedance transformer 20. Furthermore, in the case of static operation, mode selector switch 18 which may be a commercial analog switch, e.g., a switch of the type MC 14066 B sold by Motorola is switched to its conductive state, i.e., a state of low resistivity, by the output signal of trigger stage 30 which is applied to a control input of mode selector switch 18. In its conductive state, switch 18 connects the connecting point of a further voltage divider to the input of impedance transformer 20, the output of which is connected to the reference voltage input of trigger stage 22. While resistors R, R at the output of peak voltage detection circuits 15a, 15b have a high resistivity of, for example, ten times the resistivity of the resistors of the voltage divider $R', R'$ (Fig.4) cooperating with switch 18, this means that the voltage from this latter voltage divider of low resistivity overrides the voltage provided by voltage divider R, R, with the result that the voltage at the connecting point of the second voltage divider establishes the new reference voltage for trigger stage 22 via impedance transformer 20. However, the reference voltage obtained from the output voltages of peak voltage detection circuits 15a, 15b becomes effective again as soon as switch 18 is switched off in order to have a high resistivity.

Considering now in more detail the operation of trigger stage 30, it should be observed that the pulse sequence generated at the output of monostable multivibrator 26 is converted by means of low-pass filter 28 into a dc voltage of small remaining amplitude variations - low-pass filter 28 operates as a highly integrating integrator circuit. Thus the dc voltage corresponds approximately to the mean square root value of the pulse sequence. As long as no changes take place in the damping condition of the oscillator no pulses are generated by the monostable multivibrator 26 and, consequently, no voltage, or better, an extremely low voltage is present at the output of low-pass filter 28. However, the output voltage of low-pass filter 28 increases with the frequency of oscillator damping cycles and output pulses of trigger stage 22, respectively. As soon as the fre quency of the output pulses of trigger stage 22 is sufficiently high, the output voltage of low-pass filter 28 will be sufficient to actuate trigger stage 30 so as to produce an output voltage by means of which switch 18 is switched into its non-conductive state. Consequently, the circuit is switched into its dynamic operating state.

Regarding output stage 24, it should be observed that its input signal received from the output of trigger stage 22 corresponds to the condition of damping of oscillator 12. More specifically, trigger stage 22 generates a pulse sequence of individual pulses having steep front and rear edges.

These pulses may be amplified, further shaped and, as the case may be, inverted by the output stage 24 and fed to a well known digital frequency metering device including at least one counter, the count of which is evaluated periodically with the count reached at the end of each of such periodic time intervals corresponding to a certain frequency which may be shown by suitable indicator means.

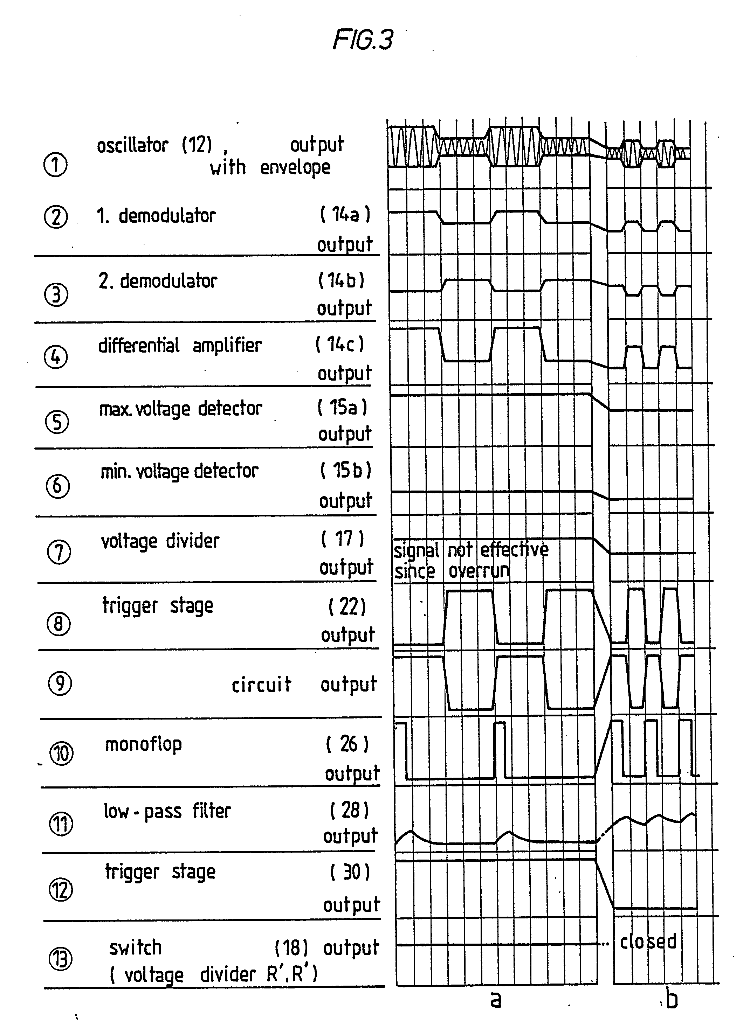

To enable more complete understanding of the invention, Figure 3 shows in a schematic manner diagrams of the voltages with respect to time for the various points of the circuit according to Figure 2 designated by encircled reference numerals 1 to 13. More specifically, in Figure 3 the various voltages for a low frequency of damping cycles are shown on the left (column a), while the situation for quick damping cycles is shown on the right (column b). Finally, Figure 4 shows a circuit diagram of a preferred embodiment of an inventive circuit configuration wherein the various components are shown by their conventional symbols. In this circuit diagram, those points for which the voltage variations are shown in Figure 3 have again been marked by encircled reference numerals 1 to 13. The circuit diagram according to Figure 4 shows the above-described voltage divider associated with the mode selector switch 18 and comprising resistors $R', R'$. Furthermore, it is apparent from the circuit diagram according to Figure 4 that trigger stage 30 may comprise an operational amplifier, the non-inverting input ( + ) of which receives a reference voltage adjustable by means of a potentiometer P.

The present disclosure relates to the subject matter disclosed in German application No. P 38 25 628.2-31 of July 28, 1988, the entire specification of which is incorporated herein by reference.

## Claims

1. A method for detecting rapid damping changes in an amplitude-modulated high-frequency oscillator signal, said damping changes resulting from the movement of objects into and out of the range of a proximity switch, comprising the steps of:

demodulating said amplitude-modulated signal to obtain an ac signal voltage that fluctuates with the frequency of damping changes;
amplifying said ac signal voltage;
converting the amplified ac signal voltage to a pulse sequence having a frequency corresponding to that of the voltage changes in said ac signal voltage; and
monitoring the frequency of said pulse sequence to detect rapid damping changes in said proximity switch.

2. A method according to claim 1, characterized in that a dynamically variable reference voltage corresponding to the damping state of the proximity switch is derived from the demodulated signal voltage for the threshold switching devices.

3. A method according to claim 2, characterized in that the mean value of the periodically sampled maximum and minimum values of the demodulated signal voltage is used as reference voltage.

4. A method according to one of claims 1 to 3, characterized in that the signal changes at the output of the threshold switching devices are continuously detected, and in that in the event of the frequency of the signal changes dropping below a given limit, a switchover is carried out from the variable reference voltage to a fixed reference voltage which is settable at a given value and vice-versa.

5. Apparatus for detecting rapid damping changes in an amplitude-modulated high-frequency oscillator signal, said damping changes resulting from the movement of objects into and out of the range of a proximity switch, comprising:
oscillator means for operating in an analog manner and generating a high-frequency oscillation;
means for amplitude-modulating said oscillation with a signal corresponding to damping changes produced by a proximity switch;
demodulator means for demodulating said amplitude-modulated oscillation to produce a demodulated signal voltage that fluctuates with the frequency of said damping changes;
ac amplifier means for amplifying said demodulated signal voltage; and
means for converting the amplified demodulated signal voltage to a pulse sequence with a frequency corresponding to the frequency of the voltage fluctuations in said demodulated signal voltage;
whereby said pulse sequence is indicative of rapid damping changes to be detected.

6. Apparatus according to claim 5, characterized in that the threshold switching devices comprise an ac amplifier (16) for generating an amplified ac voltage with the frequency of the demodulated signal voltage.

7. Apparatus according to claim 6, characterized in that the ac amplifier is designed as an amplifier with amplitude limitation and is dimensioned such that a rectangular pulse sequence is obtained at its output.

8. Apparatus according to claim 6, characterized in that the ac amplifier (16) is followed by a trigger circuit (22), the reference voltage of which is a voltage which is adapted to the operating point of the amplifier (16).

9. Apparatus according to claim 5, characterized in that the demodulator (14a, b, c) comprises separate demodulator units (14a, 14b) for demodulating the positive and the negative signal components of the amplitude-modulated oscillation of the oscillator and a differential amplifier (14c) for adding up the demodulated signal components to the demodulated signal voltage, and in that the threshold switching devices comprise a trigger circuit (22), to the input of which the demodulated signal voltage can be fed and for which a variable reference voltage can be generated with the aid of a maximum value detector (15a) and a minimum value detector (15b), the inputs of the detectors (15a, 15b) being connected to the output of the differential amplifier (14c), while their output signals are subtracted from one another to form the reference voltage.

10. Apparatus according to one of claims 5 to 9, characterized in that switchover devices (18, 26, 28, 30) are provided for applying to the threshold switching devices (22), in the event of a drop in the frequency of the signal changes at the output of the threshold switching devices (22), a settable fixed reference voltage instead of the variable reference voltage and vice-versa.

11. Apparatus according to claim 10, characterized in that the switchover devices comprise a monostable multi-vibrator (26) which is connected to the output of the threshold switching devices (22) and via a low-pass filter (28) to a trigger stage (30) by means of the output signals of which a mode selector switch (18) is controllable.

12. Apparatus according to one of claims 5 to 11, characterized in that counting devices are provided for counting the pulses of the pulse sequence generated by the threshold switching devices (22) and for producing a digital frequency or speed indication corresponding to the count that is periodically reached.

FIG. 1

EP 0 352 758 A2

FIG.2

EP 0 352 758 A2

# FIG.3

| | | | |
|---|---|---|---|
| ① | oscillator (12) , | output | with envelope |
| ② | 1. demodulator | ( 14a ) | output |
| ③ | 2. demodulator | (14b) | output |
| ④ | differential amplifier | ( 14c ) | output |
| ⑤ | max. voltage detector | ( 15a ) | output |
| ⑥ | min. voltage detector | ( 15b ) | output |
| ⑦ | voltage divider | ( 17 ) | output |
| ⑧ | trigger stage | ( 22 ) | output |
| ⑨ | | circuit | output |
| ⑩ | monoflop | ( 26 ) | output |
| ⑪ | low - pass filter | ( 28 ) | output |
| ⑫ | trigger stage | ( 30 ) | output |
| ⑬ | switch (18) output ( voltage divider R′,R′) | | |

signal not effective since overrun

closed

a          b

FIG.4

EP 0 352 758 A2